# EUROPEAN PATENT APPLICATION

(11) **EP 1 641 025 A2**
(43) Date of publication of application: **29.03.2006**
(21) Application number: 05254944.1
(22) Date of filing: 08.08.2005
(51) Int. Cl.: H01L 21/00

(54) **Film sticking method and film sticking device**

(30) Priority: 28.09.2004 JP 2004282403
(71) Applicant: TOKYO SEIMITSU CO.,LTD., Mitaka-shi Tokyo (JP)
(72) Inventor: Ametani, Minoru, Mitaka-shi Tokyo (JP)
(74) Representative: Skone James, Robert Edmund

(57) **Abstract**

There is provided a film sticking method for sticking a film on a pattern forming face of a wafer, on the pattern forming face (21) of which a circuit pattern (C) is formed, comprising the steps of: positioning the wafer (20) so that a sticking direction of a film sticking means (46) for sticking the film on the pattern forming face when the film sticking means is moved in a predetermined sticking direction (X1) on the pattern forming face of the wafer can be substantially parallel with the bisector of a corner portion of the circuit pattern; and sticking the film on the pattern forming face of the wafer when the film sticking means is moved in the sticking direction on the pattern forming face of the wafer. There is also provided a film sticking device for executing this method. Due to the foregoing, when the surface protective film is stuck, it is possible to prevent the orientation flat from being damaged and it is also possible to prevent air bubbles from being formed. When the film is peeled off after the back surface has been ground, it is preferable that the wafer is arranged in a second orientation which is rotated from the first orientation by 90°.

## Description

The present invention relates to a film sticking method for sticking a film and, especially, a film sticking method for sticking a surface protective film on the front surface of a wafer. The present invention also relates to a film sticking device for executing this film sticking method.

In the field of manufacturing semiconductors, there is a tendency that wafers are made larger in size every year. In order to increase the packing density, the wafers are made thinner. In order to make the wafers thinner, back-grinding (grinding a back surface of the wafer) is conducted. In order to protect a circuit pattern formed on the front surface of the wafer, before conducting back-grinding on the back surface, a surface protective film is stuck on the front surface of the wafer. Next, under the condition that the front surface of the wafer is sucked onto a suction table, the back surface of the wafer is ground.

Japanese Unexamined Patent Publication No. 7-14807 and Japanese Unexamined Patent Publication No. 2001-156159 disclose a film sticking device for sticking a surface protective film on a front surface of a wafer. Although detailed explanations are not disclosed in these Patent Publications, the surface protective film is stuck on the wafer by a sticking system, an outline of which is described as follows.

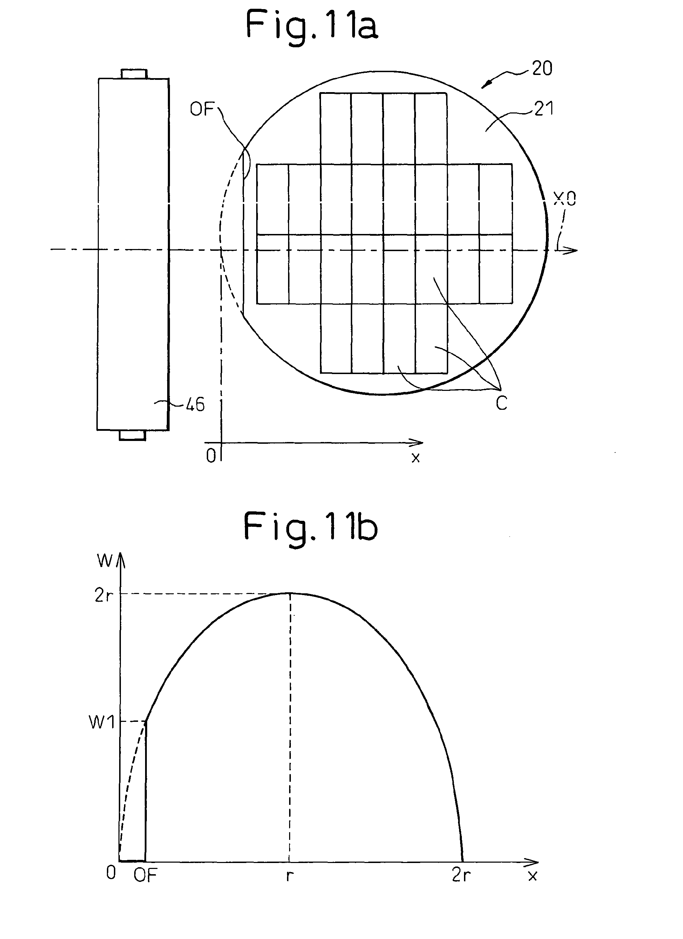

Fig. 11(a) is a schematic drawing showing a sticking system for sticking a surface protective film on a wafer according to the prior art. As shown in Fig. 11(a), on the front surface 21 of the wafer 20, a plurality of circuit patterns C are formed into a grid-shape at a doping step which is conducted before the film sticking step. As can be seen in Fig. 11(a), these circuit patterns C are formed being aligned with respect to the orientation flat, which will be referred to as the orientation flat OF hereinafter, of the wafer 20. That is, one of the sides of the rectangular circuit pattern C is arranged in parallel with the orientation flat OF. As shown in the drawing, these circuit patterns C are formed on almost all of the front surface 21 of the wafer 20. The distance between the side of the circuit pattern C, which is adjacent to the orientation flat OF, and the orientation flat OF is shorter than the distance between the other circuit pattern C and the edge portion of the wafer 20.

As shown in Fig. 11(a), the orientation flat OF of the wafer 20 is arranged in parallel with the cylindrical roller 46 as a film sticking means. Concerning the roller 46, the surface protective film 3, not shown in Fig. 11(a), is given a tension by the roller 46 according to the well known method. Accordingly, when the roller 46 is moved in the direction of arrow X0 shown in Fig. 11(a), that is, when the roller 46 is moved in the direction perpendicular to the orientation flat OF, the surface protective film 3 is continuously stuck on the front surface 21 of the wafer 20 by the roller 46.

Fig. 11(b) is a graph showing a relation between the contact width and the distance from one end of the wafer. In this case, the contact width W is defined as a linear contact region, in which the cylindrical roller 46 and the front surface 21 of the wafer 20 come into linear contact with each other, and the contact width W is in parallel with the orientation flat OF. In Fig. 11(b) etc., the radius of the wafer 20 is referred to as a radius r. As shown in Fig. 11(b), the position of the outside shape of the wafer 20 in the case where the orientation flat OF is not formed on the wafer, which is the most distant from the orientation flat OF, is defined as the origin 0. The cylindrical roller 46 first comes into contact with the orientation flat OF of the wafer 20 and then moves to the end portion on the opposite side to the orientation flat OF. Accordingly, as shown in Fig. 11(b), as the roller 46 does not come into contact with the wafer 20 in the region between the origin 0 and the outride orientation flat OF, the contact width W is zero. When the roller 46 reaches the orientation flat OF, the contact width W is instantaneously increased to W1 (< 2r). In this connection, W1 corresponds to the length of the orientation flat OF.

Therefore, at the orientation flat OF, no force is applied to the orientation flat OF by the roller 46 before the roller reaches the orientation flat OF. However, when the roller 46 reaches the orientation flat OF, a force is instantaneously applied to the orientation flat OF by the roller 46. When the orientation flat OF is instantaneously applied the force, there is a possibility that the orientation flat OF of the wafer is damaged. Even when the intensity of the force is not sufficiently high to damage the orientation flat OF, a relatively high intensity force is instantaneously applied to the circuit pattern C which is arranged adjacent to the orientation flat OF, and this adjacent circuit pattern C may be damaged.

In order to solve the above problems, Japanese Unexamined Patent Publication No. 2002-134438 discloses that the wafer 20 and the roller 46 are arranged so that the orientation flat Of of the wafer 20 and the moving direction of the roller 46 can be parallel with each other in order to stick a die bonding tape. When this system is applied to the surface protective film, a portion where the roller 46 first reaches to the wafer 20 is not the orientation flat OF. Accordingly, there is little possibility that the circuit pattern C adjacent to the orientation flat OF is damaged.

However, as disclosed in Japanese Unexamined Patent Publication No. 2002-134438, when the wafer 20 is arranged so that the orientation flat OF of the wafer 20 can be parallel with the moving direction of the roller 46, the other side of each circuit pattern C becomes parallel with the moving direction of the roller 46. That is, as the circuit pattern C is rectangular, even when the orientation flat OF of the wafer 20 is arranged in parallel with the moving direction X0 of the roller 46 as disclosed in the Japanese Unexamined Patent Publication No. 2002-134438 or when the orientation flat OF of the wafer 20 is arranged perpendicular to the moving direction X0 of the roller 46, one of the sides of the circuit pattern C becomes parallel with the orientation flat OF.

As narrow grooves are formed between the circuit patterns C, air in the grooves arranged parallel with the moving direction X0 of the roller 46 is discharged along the grooves when the roller is moved. However, air in the grooves arranged perpendicular to the moving direction X0 of the roller 46 is seldom discharged from the grooves. After the surface protective film 3 has been stuck by the roller 46, the air not discharged from the grooves remains as air bubbles between the surface protective film 3 and the wafer 20. There is a high possibility that the thus formed air bubbles can be a cause of incomplete formation of a conductor or a cause of residue in a step conducted after the step of sticking the film.

The present invention has been accomplished in view of the above circumstances. It is one object of the present invention to provide a film sticking method characterized in that: the occurrence of damage caused in an orientation flat of a wafer can be suppressed at the time of sticking a surface protective film; and the forming of air bubbles can be prevented by a relatively simple method. It is another object of the present invention to provide a film sticking device for executing this film sticking method.

In order to accomplish the above object, according to the first aspect, there is provided a film sticking method for sticking a film on a pattern forming face of a wafer, on the pattern forming face of which circuit patterns are formed, comprising the steps of: positioning the wafer so that a sticking direction of a film sticking means for sticking the film on the pattern forming face by moving the film sticking means in a predetermined sticking direction on the pattern forming face of the wafer can be substantially parallel with the bisector of a corner portion of the circuit pattern; and sticking the film on the pattern forming face of the wafer by moving the film sticking means in the sticking direction on the pattern forming face of the wafer.

In the first aspect, as the wafer is positioned so that the bisector of the corner portion of the circuit pattern can be parallel with the moving direction of the film sticking means, at the time of sticking the film, air can be uniformly discharged from the corner portion of the circuit pattern along two grooves forming the corner portion of the circuit pattern. Due to the foregoing, forming of air bubbles can be suppressed at the time of sticking the film. In the first aspect, a position where the film sticking means first arrives is not the orientation flat of the wafer. Therefore, it is possible to prevent the orientation flat from being damaged.

According to the second aspect, there is provided a film sticking method for sticking a film on a pattern forming face of a wafer, on the pattern forming face of which circuit patterns are formed, comprising the steps of: positioning the wafer in a first orientation so that a sticking direction of a film sticking means for sticking the film on the pattern forming face by moving the film sticking means in a predetermined sticking direction on the pattern forming face of the wafer can be substantially parallel with the bisector of a corner portion of the circuit pattern; sticking the film on the pattern forming face of the wafer by moving the film sticking means in the sticking direction on the pattern forming face of the wafer; grinding a face on the opposite side to the pattern forming face of the wafer; positioning the wafer in a second orientation rotated by 90° round the centeraxis of the wafer from the first direction; feeding a peeling tape onto the film stuck on the pattern forming face of the wafer; contacting the peeling tape with the film on the wafer; and peeling the film together with the peeling tape from the pattern forming face on the wafer by moving a film peeling means in a peeling direction, which is parallel with the sticking direction, on the pattern forming face of the wafer.

In the second aspect, as the wafer is positioned so that the bisector of the corner portion of the circuit pattern can be parallel with the moving direction of the film sticking means, at the time of sticking the film, air can be uniformly discharged from the corner portion of the circuit pattern along two grooves forming the corner portion of the circuit pattern. Due to the foregoing, air bubbles can be suppressed at the time of sticking the film. In the second aspect, a position where the film sticking means first arrives is not the orientation flat of the wafer. Therefore, it is possible to prevent the orientation flat from being damaged. Further, as the wafer is rotated by 90° from the first orientation, the film peeling action is started from a portion where stress applied to the wafer at the time of sticking the film is relatively low. That is, a force applied to the wafer at the time of peeling the film is applied to a portion where stress applied at the time of sticking the film was relatively low. Accordingly, in the second aspect, it is possible to prevent the wafer from being damaged by the force. Even after the wafer was rotated by 90° from the first orientation to the second orientation, the bisector of another corner portion of the circuit pattern becomes parallel with the moving direction of the peeling tape sticking means. Therefore, the adhesive of the film is uniformly released from the corner portion of the circuit pattern. Accordingly, it is possible to prevent the residues of the adhesive from remaining in the groove between the circuit patterns.

According to the third aspect, in the first or second aspect, the wafer is previously cut by dicing operation to an intermediate portion of the wafer thickness.

That is, according to the third aspect, the film can be stuck even on a wafer which has already been half-cut by means of dicing.

According to the fourth aspect, there is provided a film sticking device of sticking a film on a pattern forming face of a wafer, on the pattern forming face of which circuit patterns are formed, comprising: a positioning means for supportably positioning the wafer; and a film sticking means for sticking the film on the pattern forming face by moving the film sticking means in a predetermined sticking direction on the pattern forming face of the wafer wherein, after the wafer is positioned by the positioning means so that the sticking direction of the film sticking means can be substantially parallel with the bisector of a corner portion of the circuit pattern, the film is stuck on the pattern forming face of the wafer by moving the film sticking means in the sticking direction on the pattern forming face of the wafer.

In the fourth aspect, as the wafer is positioned so that the bisector of the corner portion of the circuit pattern can be parallel with the moving direction of the film sticking means, at the time of sticking the film, air can be uniformly discharged from the corner portion of the circuit pattern along two grooves forming the corner portion of the circuit pattern. Due to the foregoing, air bubbles can be suppressed at the time of sticking the film. In the fourth aspect, a position where the film sticking means first arrives is not the orientation flat of the wafer. Therefore, it is possible to prevent the orientation flat from being damaged.

According to the fifth aspect, there is provided a film sticking device of sticking a film on a pattern forming face of a wafer, on the pattern forming face of which circuit patterns are formed, comprising: a positioning means for supportably positioning the wafer; a film sticking means for sticking the film on the pattern forming face by moving the film sticking means in a predetermined sticking direction on the pattern forming face of the wafer; a grinding means for grinding a face on the side opposite to the pattern forming face of the wafer; a tape feeding means for feeding a peeling tape onto the film stuck on the pattern forming face of the wafer; and a film peeling means for peeling the film together with the peeling tape from the pattern forming face of the wafer by moving the film peeling means in a peeling direction parallel with the sticking direction on the pattern forming face, wherein after the wafer is positioned by the positioning means in a first orientation so that the sticking direction of the film sticking means can be substantially parallel with the bisector of a corner portion of the circuit pattern, the film is stuck on the pattern forming face of the wafer by moving the film sticking means in the sticking direction on the pattern forming face of the wafer, after a face on the opposite side to the pattern forming face is ground by the grinding means, the wafer is positioned by the positioning means in a second orientation rotated by 90° round the center axis of the wafer from the first direction so as to contact the film of the wafer with the peeling tape fed by the feeding means, and the film is peeled from the pattern forming face of the wafer together with the peeling tape by moving the film peeling means in a peeling direction parallel with the sticking direction on the pattern forming face.

In the fifth aspect, as the wafer is positioned so that the bisector of the corner portion of the circuit pattern can be parallel with the moving direction of the film sticking means, at the time of sticking the film, air can be uniformly discharged from the corner portion of the circuit pattern along two grooves forming the corner portion of the circuit pattern. Due to the foregoing, air bubbles can be suppressed at the time of sticking the film. In the fifth aspect, a position where the film sticking means first arrives is not the orientation flat of the wafer. Therefore, it is possible to prevent the orientation flat from being damaged. Further, as the wafer is rotated by 90° from the first orientation, the film peeling action is started from a portion where stress applied to the wafer at the time of sticking the film is relatively low. That is, a force applied to the wafer at the time of peeling the film is applied to a portion where stress applied at the time of sticking the film was relatively low. Accordingly, in the fifth aspect, it is possible to prevent the wafer from being damaged by the force. Even after the wafer was rotated by 90° from the first orientation to the second orientation, the bisector of another corner portion of the circuit pattern becomes parallel with the moving direction of the peeling tape sticking means. Therefore, the adhesive of the film is uniformly released from the corner portion of the circuit pattern. Accordingly, it is possible to prevent the residues of the adhesive from remaining in the groove between the circuit patterns.

According to the sixth aspect, in the fourth or the fifth embodiment, the wafer is previously cut by dicing operation to an intermediate portion of the wafer thickness.

That is, according to the sixth aspect, in the fourth or fifth aspect, the film can be stuck according to this aspect on a wafer which has already been half-cut by means of dicing.

According to each aspect, it is possible to provide a common advantage of preventing the orientation flat from being damaged and air bubbles from being formed at the time of sticking the surface protective film.

Further, according to the second and the fifth aspect, it is possible to provide an advantage that the wafer is prevented from being damaged at the time of peeling the film. Further, it is possible to provide an advantage that the residues of the adhesive of the film can be prevented from remaining in the groove between the circuit patterns.

Further, according to the third and the sixth aspect, it is possible to provide an advantage that the film can be stuck according to these embodiments on a wafer which has already been half-cut by dicing operation.

These and other objects, features and advantages of the present invention will be more apparent in light of the detailed description of exemplary embodiments thereof as illustrated by the drawings.

### In the drawings:

Fig. 1 is a schematic drawing showing a wafer processing device according to the present invention;
Fig. 2 is a schematic sectional view showing a sticking unit in the wafer processing device;
Fig. 3a is a schematic plan view showing a wafer and roller in the sticking unit;
Fig. 3b is a graph showing a relation between the contact width and the distance from one end of the wafer in the present invention;
Fig. 4 is a partially enlarged view in which a front surface of the wafer is partially enlarged;
Fig. 5a is a sectional view of the wafer taken on a line segment perpendicular to the pattern groove "ga" after the surface protective film has been stuck;
Fig. 5b is another schematic plan view showing a wafer and roller in the sticking unit;
Fig. 6a is a schematic side view showing a state of grinding a back surface in the back surface grinding unit;
Fig. 6b is a schematic side view showing a state of the wafer after the back surface has been ground;
Fig. 7 is a schematic sectional view showing a peeling unit in the wafer processing device;
Fig. 8 is a schematic plan view showing a wafer and peeling roller in the peeling unit;
Fig. 9a is a schematic plan view showing a wafer, which has been half-cut in the sticking unit, and also showing a roller;
Fig. 9b is a sectional view taken on line A - A in Fig. 9a;
Fig. 10 is a sectional side view for explaining laser beam dicing;
Fig. 11a is a schematic drawing showing a sticking system at the time of sticking a surface protective film onto a wafer in the prior art; and
Fig. 11b is a graph showing a relation between the contact width and the distance from one end portion of the wafer in the prior art.

Referring to the accompanying drawings, an embodiment of the present invention will be explained below. In the following drawings, like parts are indicated by the same reference characters. In order to facilitate understanding, the scale is appropriately changed in these drawings.

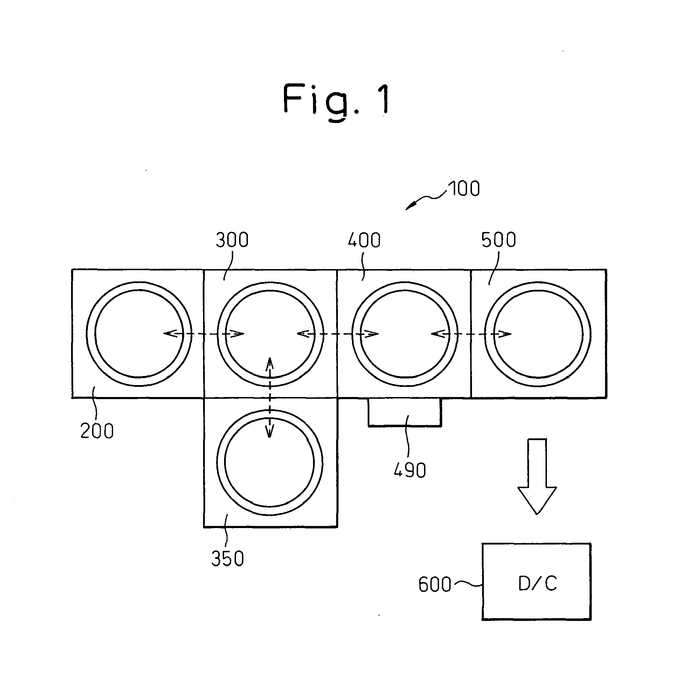

Fig. 1 is a schematic drawing showing a wafer processing device according to the present invention. To the wafer processing device 100 shown in Fig. 1, the wafers 20, on the front surface 21 of which a plurality of circuit patterns C are formed in a grid-shape, are supplied. As shown in Fig. 1, the wafer processing device 100 includes a sticking unit 200 for sticking the surface protective film 3 on the wafer 20.

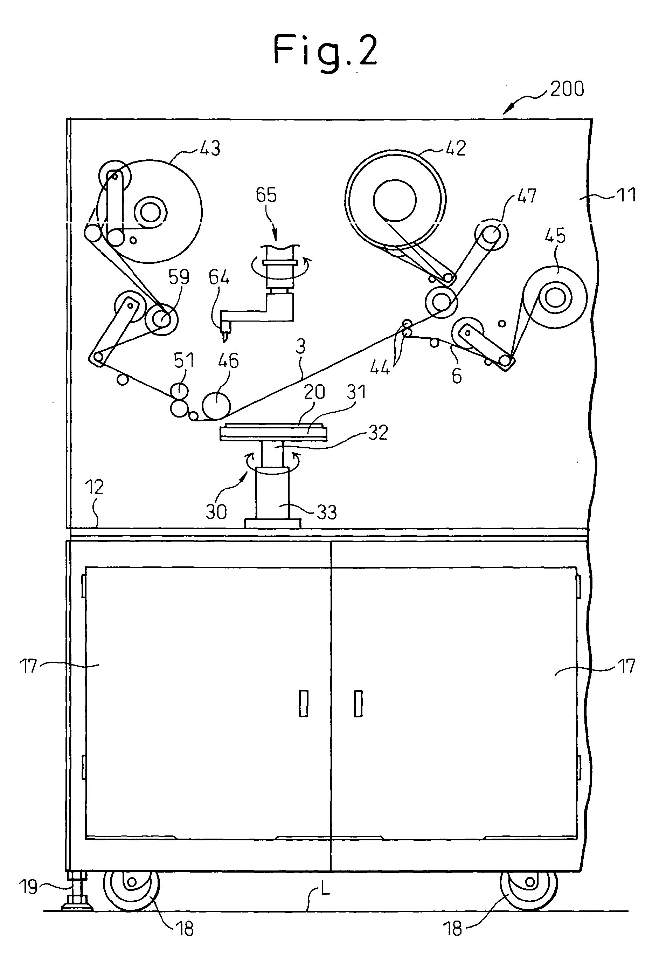

Fig. 2 is a schematic sectional view of the sticking unit in the wafer processing device. The sticking unit 200 shown in Fig. 2 includes: a supply section 42 for supplying the surface protective film 3 to be stuck on the wafer 20; and a winding section 43 for winding a tape supplied from the supply section 42. These supply section 42 and winding section 43 are arranged in the housing 11 of the sticking unit 200. As shown in the drawing, a plurality of casters 18 and stoppers 19 are provided on the bottom face of the housing 11. The sticking unit 200 can be moved to a desired position on the floor L by the casters 18 and fixed at the position by the stoppers 19. The door 17 is provided in a lower portion of the sticking unit 200. When this door 17 is opened, it is possible for an operator to have access to the control section 80 (not shown in the drawing) arranged in the lower portion of the sticking unit 200 and, for example, it is possible for an operator to have access to a digital computer.

As shown in Fig. 2, the guide rollers 47 for guiding the surface protective tape 3 and giving a predetermined tension to the surface protective tape 3 are provided in the downstream of the supplying section 42. Further, a pair of peeling rollers 44 are provided in the downstream of the guide rollers 47. The peeling rollers 44 have a function of peeling the release 6 from the surface protective film 3. The release 6 is wound up by the release winding section 45. On the other hand, downstream of the peeling roller 44, the guide roller 51 to guide the surface protective film 3 and the winding section 43 to wind up the surface protective film 3 are provided. Between the guide rollers 51 and the winding section 43, the dancer roller 59, which moves according to the length of the surface protective film 3 that has been drawn out from the supplying section 42, is provided.

As shown in Fig. 2, the table elevating section 30 is arranged on the shelf plate 12 provided in the intermediate portion of the sticking unit 200. The suction table 31 provided in the table elevating section 30 can support the wafer 20 by a sucking action. The substantially cylindrical base 33 of the table elevating section 30 is arranged on the shelf plate 12. A forward end portion of the shaft 32 extending from the lower face of the suction table 31 is inserted into the substantially cylindrical base 33. The table elevating section 30 is connected to the actuator 50 not shown in the drawing. The suction table 31 is elevated by this actuator 50 and is capable of rotating round the shaft 32. In this connection, when the wafer 20 is set on the table 31, the centerline of the wafer 20 coincides with the centerline of the shaft 32. The actuator 50 is connected to the computer provided in the control section 80 via an electropneumatic proportional valve not shown in the drawing, so that the height and position of the suction table 31 can be adjusted.

As shown in Fig. 2, the roller 46, which is reciprocated in the horizontal direction in the housing 11, is arranged in an upper portion of the table elevating section 30. The length of the roller 46 is larger than the maximum length of the wafer 20 and the suction table 31. Although not shown in the drawing, for example, the roller 46 is connected to an endless chain provided between two pulleys, and the pulley is connected to a motor not shown. When the motor is rotated in the normal and the reverse direction, the roller 46 can be reciprocated between the pulleys in the horizontal direction. Of course, the roller 46 may be reciprocated in the horizontal direction by another driving mechanism.

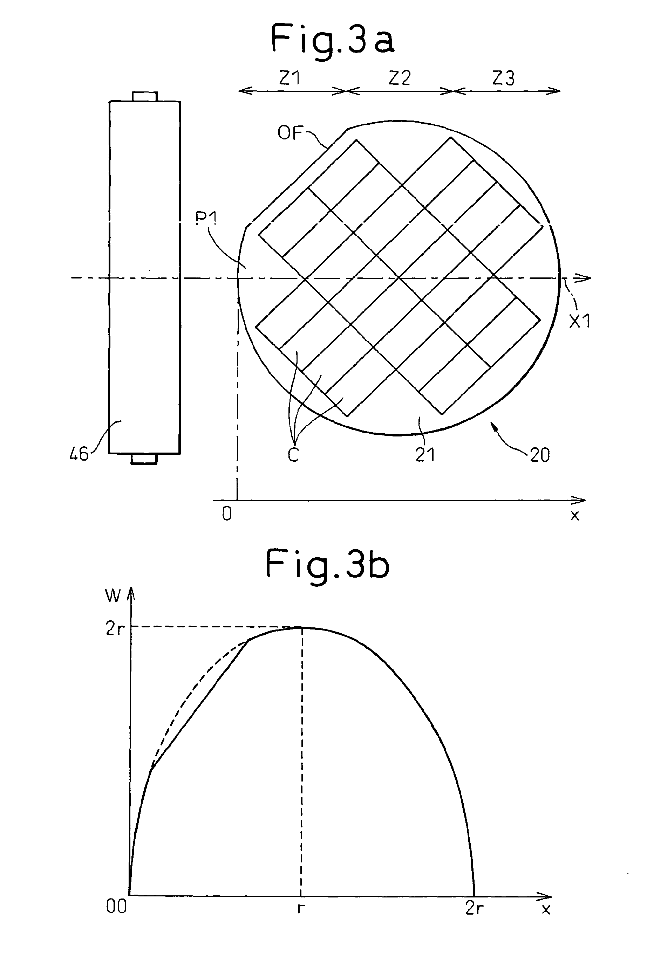

Fig. 3a is a schematic plan view showing a wafer and roller in the film sticking unit. In order to facilitate understanding, members except for the wafer 20 and the roller 46 are omitted in Fig. 3a. However, the surface protective film 3 actually exists in the positional relation shown in Fig. 2.

Usually, when the wafer 20 is set on the suction table 31, the orientation flat OF of the wafer 20 is set in parallel with or perpendicular to the moving direction X1 of the roller 46. However, according to the present invention, after the suction table 31 has been raised to a predetermined height, the suction table 31 is rotated round the shaft 32, so that the moving direction X1 of the roller 46 and the orientation flat OF of the wafer 20 can form an angle of about 45°. This positional relation is determined so that the bisector of the corner portion of the circuit pattern C, which is previously formed on the surface 21 of the wafer 20, and the moving direction X1 of the roller 46 can be parallel with each other. Of course, after the wafer 20 has been rotated by a predetermined angle by an alignment device specially provided, the wafer 20 may be arranged on the suction table 31.

Usually, the circuit pattern C is rectangular, and the angle of the corner portion of the circuit pattern C is 90°. Further, usually, the orientation flat OF of the wafer 20 and one side of the circuit pattern C are parallel with each other. Accordingly, in the case where the wafer 20 is set on the suction table 31 so that the orientation flat OF and the moving direction X1 of the roller 46 can be parallel with or perpendicular to each other, the rotational angle of the suction table 31 is 45°. Of course, in the case where the orientation flat OF and the moving direction X1 are not parallel with or perpendicular to each other when the wafer 20 is set on the suction table 31, the rotational angle of the suction table 31 is different.

After the wafer 20 and the roller 46 has been arranged so that the positional relation shown in Fig. 3a can be established, the roller 46 is moved in the moving direction X1 from one end of the wafer 20 to the other end through the diameter of the mater 20. Due to the foregoing, the surface protective film 3 can be stuck onto the surface 21 of the wafer 20.

Fig. 3b is a graph showing a relation between the contact width W and the distance from one end of the wafer in the present invention. In Fig. 3b, the axis of ordinate shows a linear contact region in which the roller 46 and the surface 21 of the wafer 20 are linearly contacted with each other, that is, the axis of ordinate shows a contact width W, and the axis of abscissas shows a distance in the case where the end portion P1 of the wafer 20, at which the roller 46 first arrives, is assumed to be the origin. In the present invention, the wafer 20 on the suction table 31 is rotated so that the bisector of the corner portion of the circuit pattern C and the moving direction X1 can be parallel with each other. Therefore, the roller 46 first arrives at the portion P1 which is not the orientation flat OF of the wafer 20. Accordingly, as shown in Fig. 3b, the contact width W is not instantaneously raised but relatively gradually raised, which is different from the case of the prior art. That is, according to the present invention, a force is given from the roller 46 so that the force can be gradually increased from the end portion of the wafer 20. Therefore, according to the present invention, it is possible to prevent the orientation flat OF of the wafer 20 from being damaged. As a result, it is possible to prevent the circuit pattern, which is arranged adjacent to the orientation flat OF of the wafer 20, from being damaged.

After that, as shown in Fig. 3b, when the roller 46 passes through the orientation flat OF, the ratio of the increase in the contact width W is a little reduced. However, when the roller 46 has completely passed through the orientation flat OF, the ratio of the increase in the contact width W is raised again. Then, when the distance exceeds the radius r of the wafer 20, the contact width W is gradually reduced and finally becomes zero.

In this connection, in the present invention, the force F given to the wafer 20 by the roller 46 is constant. Accordingly, when the contact width W is changed as shown in Fig. 3b, stress generated in the wafer 20, which comes into contact with the roller 46 via the surface protective film 3, is also changed according to the contact width W. The stress can be calculated when the force F given by the roller 46 is divided by the contact width W. Accordingly, the following can be understood, referring to Fig. 3b. The stress P is high immediately after the start of the contact of the roller 46. When the roller 46 is moving in the neighborhood of the center of the wafer 20, the stress P is low. When the roller 46 passes through the center of the wafer 46 and moves toward an end portion on the opposite side to the wafer 20, the stress P is increased again. In the present invention, a region in the neighborhood of the center of the wafer 20, in which the stress P is relatively low, will be referred to as the region Z2, and regions in the neighborhoods of both end portions of the wafer 20, in which the stress P is relatively high, will be referred to as the regions Z1 and Z3. Concerning these regions Z1, Z2 and Z3, refer to Fig. 3a.

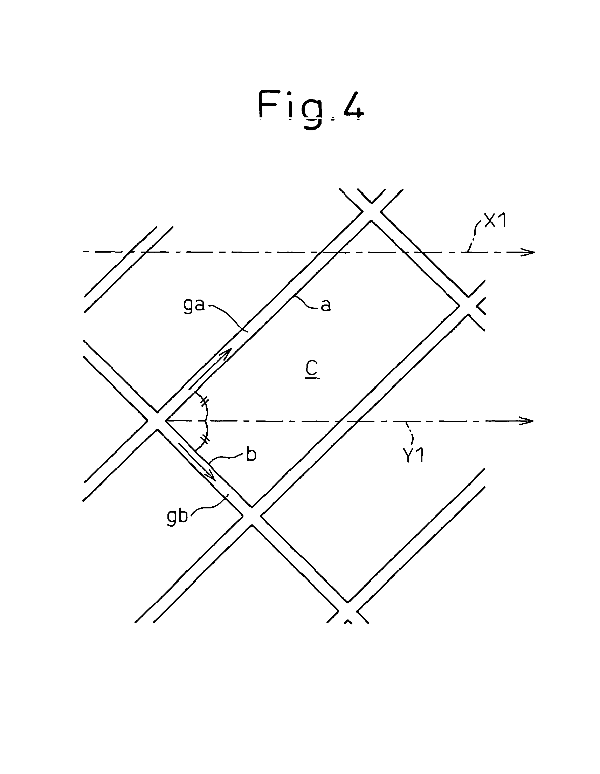

Fig. 4 is a partially enlarged schematic illustration in which the wafer surface is partially enlarged. Attention is given to the circuit pattern C which is one of the plurality of circuit patterns formed on the surface 21 of the wafer 20 shown in Fig. 4. The circuit pattern C concerned is substantially a rectangle having the long sides "a" and the short sides "b". Between the circuit patterns which are adjacent to each other, the pattern grooves "ga" and "gb", which respectively correspond to each side, are formed. These pattern grooves "ga" and "gb" are previously formed in the process conducted before.

As described before, in the present invention, the suction table 31 is rotated so that the moving direction X1 of the roller 46 can be parallel with the bisector Y1 of the corner portion of the circuit pattern. Accordingly, the angle formed between the pattern groove "ga" shown in Fig. 4 and the moving direction X1 is the same as the angle formed between the pattern groove "gb" and the moving direction X1. Therefore, when the roller 46, not shown in Fig. 4, is moved along the moving direction X1 as shown in Fig. 4, air in the pattern grooves "ga" and "gb" is uniformly discharged along the pattern grooves in the direction of the arrow shown in the drawing. Accordingly, after the surface protective film 3 has been stuck, air bubbles are seldom formed in the pattern grooves "ga" and "gb". Further, in the present invention, the angle formed between the pattern groove "ga" and the moving direction X1 is the same as the angle formed between the pattern groove "gb" and the moving direction X1. Therefore, the degree of suppression of air bubbles in the pattern groove "ga" can be made to be substantially equal to the degree of suppression of air bubbles in the pattern groove "gb".

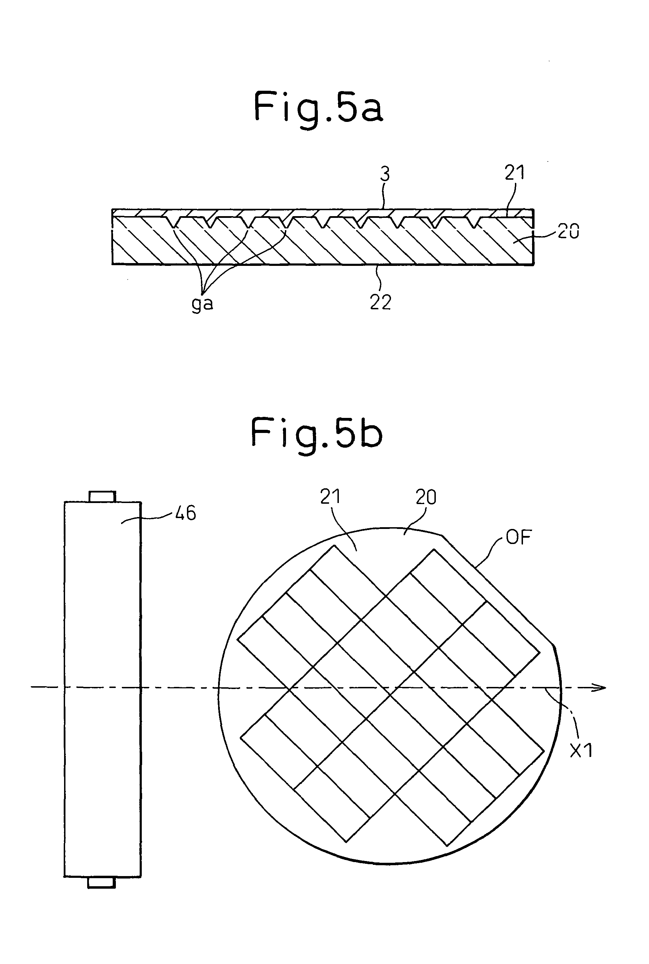

Fig. 5a is a sectional view of the wafer 20 taken on the line perpendicular to the pattern groove "ga" after the surface protective film has been stuck. In the present invention, as described before, air in the pattern grooves "ga" and "gb" is discharged when the surface protective film 3 is stuck. Accordingly, the surface protective film 3 enters the pattern grooves "ga" and "gb" by a quantity corresponding to the air discharged from the pattern grooves "ga" and "gb". Therefore, it is possible to enhance the degree of adhesion of the surface protective film 3.

In this connection, in the case shown in Fig. 3a, the suction table 31 is rotated so that the orientation flat OF of the wafer 20 can be arranged on the side close to the initial position of the roller 46. However, for example, as shown in Fig. 5b, the wafer 20 may be positioned so that the orientation flat OF of the wafer 20 can be arranged on the side distant from the initial position ot the roller 46. Although not shown in the drawing, the orientation flat OF may be arranged on either the right or the left of the moving direction X1. That is, the present invention also includes a case in which the suction table 31 is rotated so that the orientation flat OF can be positioned on the lower side of the moving direction X1 in Figs. 3a and 5b.

After the surface protective film 3 has been stuck as described above, a portion in which the surface protective film 3 has been stuck is cut off from the remaining portion of the surface protective film 3. Referring to Fig. 2 again, the cutter unit 65 is provided in an upper portion of the table elevating section 30 and the roller 46. The cutter unit 65 is capable of reciprocating in the perpendicular direction and is provided with a rotary cutter 64. After the tape has been stuck, the cutter unit 65 is moved to the wafer 20. Next, when the cutter 64 is rotated along the peripheral edge of the wafer 20, the surface protective film 3, which has been stuck to the wafer 20, can be cut off.

Referring to Fig. 1 again, the wafer 20, on the surface 21 of which the surface protective film 3 is stuck, is supplied to the reversal unit 300 of the wafer processor 100. The reversal unit 300 reverses the wafer 20. In the sticking unit 200, the surface 21 of the wafer 20, on the surface 21 of which the surface protective film 3 is stuck, is directed upward. Accordingly, in the reversal unit 300, the aforementioned wafer 20 is reversed with respect to the upper and lower sides, and the front surface 21 of the wafer 20, onto which the surface protective film 3 is stuck, is directed downward. Of course, it is also possible that the wafer 20 is made to simply pass through the reversal unit 300 without being reversed.

In this connection, a moving device, for example, a robot arm is used when the wafer 20 is moved between the sticking unit 200 and the reversal unit 300 or between the other units described later. This moving unit is of the type commonly used. Therefore, a drawing and an explanation of the moving unit are omitted here.

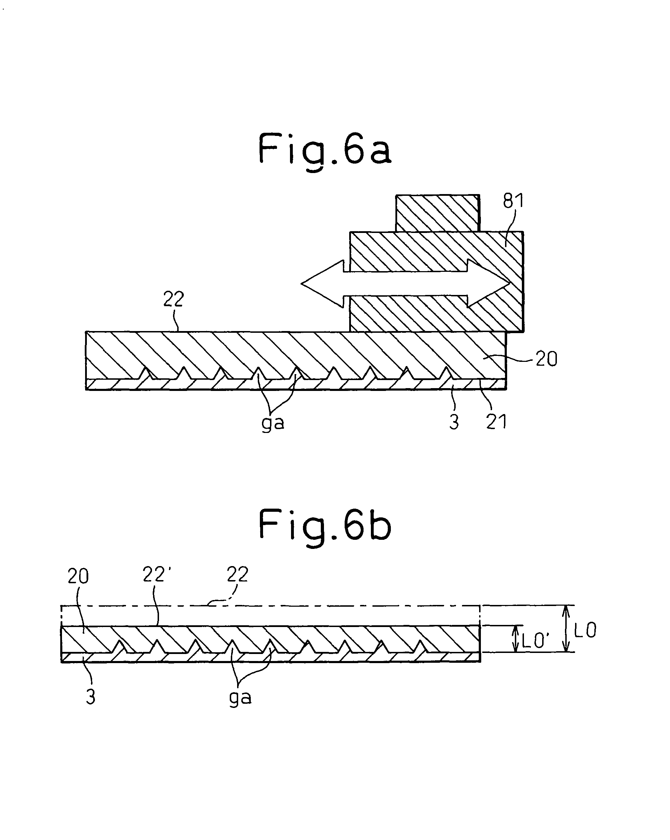

After the wafer 20 has been reversed in the reversal unit 300, it is supplied to the back surface grinding unit 350. The wafer 20 is supplied to the back surface grinding unit 350 while the back surface is being directed upward. Fig. 6a is a schematic side view showing a state in which the back surface of the wafer 20 is ground in the back surface grinding unit. As shown in Fig. 6a, the front surface 21 of the wafer 20 is sucked by a sucking section not shown in the back surface grinding unit 350. As described before, in the sticking unit 200, the surface protective film 3 is stuck onto the front surface 21 of the wafer 20. Therefore, even when the front surface 21 of the wafer 20 is sucked, the circuit pattern C formed on the front surface 21 of the wafer 20 is not damaged.

Next, the grinding section 81 is arranged on the back surface 22 of the wafer 20. Then, as illustrated in Fig. 6a, the grinding section 81 reciprocates on the back surface 22 of the wafer 20 in the arrowed direction. As illustrated in Fig. 6b, which is a schematic side view showing the wafer 20, the back surface of which has been ground, the back surface 22 of the wafer 20 is ground by the grinding section 81, and the thickness of the wafer 20 is reduced from the initial thickness L0 to L0' which is the thickness after the completion of grinding. When the wafer 20 is ground to a predetermined thickness, for example, when the wafer 20 is ground to the thickness L0', operation of the grinding section 81 is stopped, and the wafer 20 is returned from the back surface grinding unit 350 to the reversal unit 300. The wafer 20 is reversed again in the reverse unit 300. Due to the foregoing, the front surface 21 of the wafer 20 is directed upward.

In this connection, in a certain type of surface protective film 3, when the surface protective film 3 is irradiated with a predetermined quantity of ultraviolet rays, the adhesive strength of the surface protective film 3 decreased. When this type of surface protective film 3 is employed, the ultraviolet rays irradiating unit of the wafer processing device 100 shown in Fig. 1 can be utilized, that is, UV irradiating unit 400 can be utilized. The wafer 20 is reversed in the reversal unit 300 and the front surface 21 is directed upward. Under this condition, the wafer 20 is supplied to a UV irradiating unit 400. Accordingly, in the UV irradiating unit 400, the surface protective film 3 is irradiated with a predetermined quantity of ultraviolet rays by a UV lamp 490. Next, the wafer 20 is supplied to the peeling unit 50. In this connection, in the case where the surface protective film 3, the adhesive strength of which is not changed by the irradiation of ultraviolet rays, is used, it is unnecessary to irradiate ultraviolet rays to the wafer 20 in UV irradiating unit 400. Therefore, the wafer 20 simply passes through UV irradiating unit 400.

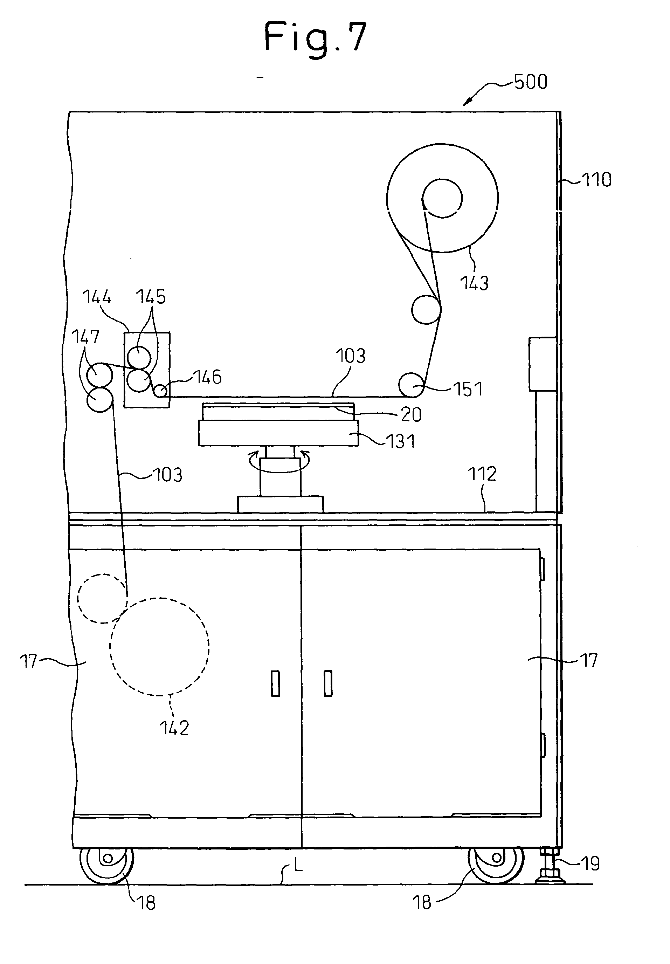

Finally, the wafer 20 is supplied to the peeling unit 500. Fig. 7 is a schematic sectional view of the peeling unit provided in the wafer processing device. The tape peeling unit 500 shown in Fig. 7 includes: a supplying section 142 for supplying the peeling tape 103 into the housing 110; and a winding section 143 for winding up the tape sent from the supplying section 142. The peeling tape 103 used in the tape peeling unit 500 is used for peeling the surface protective film 3 which is stuck on the front surface of the wafer 20. The width of this peeling tape 103 is smaller than the diameter of the wafer 20. The width of this peeling tape 103 is approximately half of the diameter of the wafer 20 in this embodiment.

As shown in the drawing, a plurality of casters 18 and stoppers 19 are provided on the bottom face of the housing 110. In Fig. 2, one caster 18 and stopper 19 are respectively shown. These are the same as those explained before referring to Fig. 2. Therefore, the explanations are omitted here. The same control section as that described before is incorporated into the door 17 located in a lower portion of the peeling unit 500. The other units are composed in the same manner.

As shown in Fig. 7, a pair of guide rollers 147 for guiding the peeling tape 103 and giving a predetermined tension to the peeling tape 103 are provided in the downstream of the supplying section 142. Further, the peeling section 144 is provided in the downstream of the guide rollers 147 and in the upstream of the suction table 131. As can be seen in Fig. 7, the peeling section 144 includes: a pair of rollers 145; and a peeling roller 146 located in the right downstream of the rollers 145. The width of the peeling roller 146 is larger than the maximum width of the suction table 131.

Although not shown in the drawing, for example, a portion of the peeling section 144 is connected to an endless chain which is provided between two pulleys. These pulleys are connected to a motor not shown. When the motor is rotated in the normal and the reverse direction, the entire peeling section 144 can be reciprocated in the horizontal direction between the pulleys. Of course, the peeling section 144 may be reciprocated in the horizontal direction by another drive mechanism. As described later in detail, when the peeling section 144 is moved in the horizontal direction through the diameter of the wafer 20 from one end of the wafer 20 to the other end of the wafer, the peeling tape 103 can be peeled off from the front surface of the wafer 20. In the downstream of the peeling section 144, the guide roller 151 for guiding the peeling tape 103 and the winding section 143 for winding the peeling tape 103 are provided.

Further, when the peeling tape 103 is drawn out from the supply section 142, the peeling tape 103 is located above the suction table 131. At this time, the peeling tape 103 is located on the diameter of the suction table 131. The suction table 131 can be elevated and rotated in the same manner as that of the suction table 31.

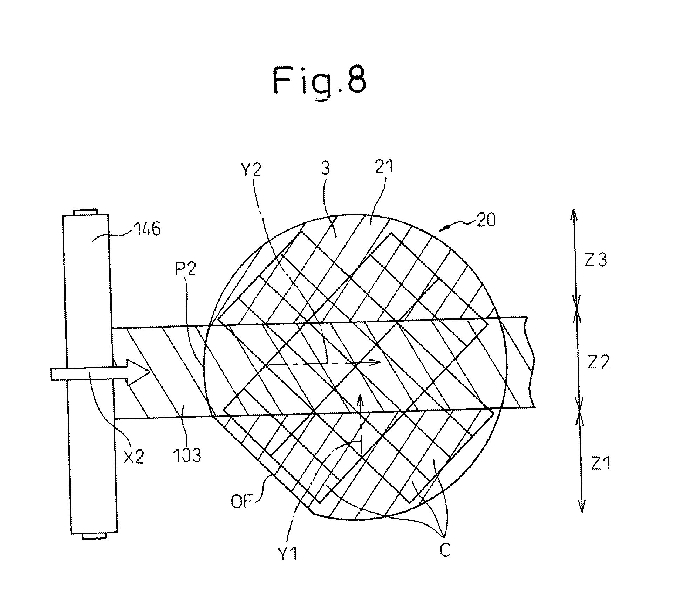

Fig. 8 is a schematic plan view showing a wafer and peeling roller in the peeling unit. The surface protective film 3 is stuck onto the front surface 21 of the wafer 20 shown in Fig. 8. In the present invention, in the same manner as that explained referring to Fig. 4, after the wafer 20 has been set on the suction table 131, the suction table 131 is rotated to position the wafer so that the bisector Y2 of another corner portion of the circuit pattern C formed on the front surface 21 of the wafer 20 can be parallel with the moving direction X2. The bisector Y2 employed at the time of peeling the surface protective film 3 is perpendicular to the bisector Y1 employed at the time of sticking the surface protective film 3. As a result, as shown in Fig. 8, an angle formed between the moving direction X2 of the peeling roller 146 and the orientation flat OF of the wafer 20 is approximately 45°. In other words, the orientation of the wafer 20 shown in Fig. 8 is shifted from the orientation of the wafer 20 shown in Fig. 3a by 90° round the centerline of the wafer 20. At this time, the regions Z1 and Z3 shown in Fig. 3a, the stress of which is relatively high, are located in the substantial outside of the peeling tape 103, and the region Z2, the stress of which is relatively low, is located in the region where the peeling tape 103 exists.

In this connection, in the case where the position of the orientation flat OF in the sticking unit 200 is not changed even after the wafer 20 has passed through the reversal unit 300, the back surface grinding unit 350 and UV irradiating unit 400, the suction table 131 of the peeling unit 500 may be simply rotated counterclockwise by 90°. In this case, the state shown in Fig. 8 can be also provided.

Next, the suction table 131 is raised toward the peeling table 103. As a distance between the peeling tape 103 and the shelf plate 112 is previously known, when the suction table 131 is raised according to this distance, the surface protective film 3 of the wafer 20 and the peeling tape 103 can be contacted with each other. Due to the foregoing, an adhesion force higher than the adhesion force between the surface protective film 3 and the wafer 20 can be obtained between the peeling tape 103 and the surface protective film 3. However, even in this case, the adhesion force between the peeling tape 103 and the surface protective film 3 is not higher than the adhesion force between the wafer 20 and the suction table 131. After the above state has occurred, the peeling section 144 is driven.

The peeling section 144 is slid from the left to the right in Fig. 7. At the same time, the winding section 143 is driven so as to wind the peeling tape 103. As described before, the adhesion force between the peeling tape 103 and the surface protective film 3 is higher than the adhesion force between the surface protective film 3 and the wafer 20. When the peeling section 144 is moved, the peeling roller 146 first arrives at the portion P2 which is not the orientation flat OF of the wafer 20. As the winding section 143 is being driven, the surface protective film 3 is peeled off from this portion P2 together with the peeling tape 103.

As can be seen in Fig. 8, the portion P2 of the wafer 20 is located in the region Z2, the stress P of which is relatively low at the time of sticking the surface protective film 3. That is, in the present invention, the peeling action is started from the portion P2 in the region Z2 in which the stress P was relatively low. Of course, the peeling start portion P2 is given a relatively high stress, however, this portion P2 was given a low stress P at the time of sticking the surface protective film 3. The regions Z1 and Z3, in which the stress P was relatively high at the time of sticking the surface protective film 3, are not the peeling start portions.

That is, according to the present invention, the wafer 20 is positioned so that the portion in which stress is given at the time of sticking the surface protective film 3 and the portion in which stress is given at the time of peeling the surface protective film 3 are different from each other in the wafer 20. Therefore, according to the present invention, it is possible to avoid the occurrence of a case in which the stress at the time of sticking the surface protective film 3 and the stress at the time of peeling the surface protective film 3 are given to the same portion. Therefore, it is possible to prevent the wafer 20 from being damaged at the time of peeling the surface protective film 3.

As the moving direction X2 of the peeling roller 146 and the bisector Y2 of the corner portion of the circuit pattern C are parallel with each other, it is possible to refer to Fig. 4 even when the surface protective film 3 is peeled off. When Fig. 4 is referred to, the moving direction X1 in Fig. 4 is replaced with the moving direction X2, and the roller 46 is replaced with the peeling roller 146. When the surface protective film 3 is peeled off by moving the peeling roller 146 in the moving direction X2, as can be estimated from Fig. 4, the pattern grooves "ga" and "gb" are respectively given an equal intensity of force. Accordingly, there is no possibility that a large quantity of adhesive agent of the surface protective film 3 is left only in one of the pattern grooves "ga" and "gb". That is, the adhesive agent of the surface protective film 3 uniformly leaves the corner portion of the circuit pattern along the pattern grooves "ga" and "gb". Due to the foregoing, it is possible to prevent the adhesive agent from remaining in the pattern grooves "ga" and "gb" as the residues.

In this connection, referring to Figs. 3a and 8, the wafer 20 is positioned in a state in which the wafer 20 is rotated counterclockwise by 90°. However, the wafer 20 may be positioned in a state in which the wafer 20 is rotated clockwise by 90°. It can be understood that the peeling start portion P2 is positioned in the region Z2 even in this case.

Referring again to Fig. 1, the wafer 20, from which the surface protective film 3 has been peeled off in the peeling unit 500, is conveyed to the dicing device 600. Although the detailed explanations are omitted here, the wafer 20 is diced along the pattern grooves "ga" and "gb" of the circuit pattern in the dicing device. In this connection, the dicing device 600 shown in Fig. 1 may be a common dicing device having a dicer blade. Alternatively, the dicing device 600 shown in Fig. 1 may be a laser beam dicing device described later.

In the above embodiment, explanations are made into the wafer 20 which is diced by the dicing device not shown in the drawing after the back surface of the wafer 20 has been ground in the back surface grinding unit 350. However, even in the case where the surface protective film 3 is stuck onto the wafer 20 after the dicing operation and then the back surface is ground, it is possible to employ the wafer processing device 100 of the present invention. However, in this case, dicing is not a so-called full-cut dicing in which the wafer 20 is perfectly cut off but dicing is a so-called half-cut in which cutting is conducted on half the thickness of the wafer 20.

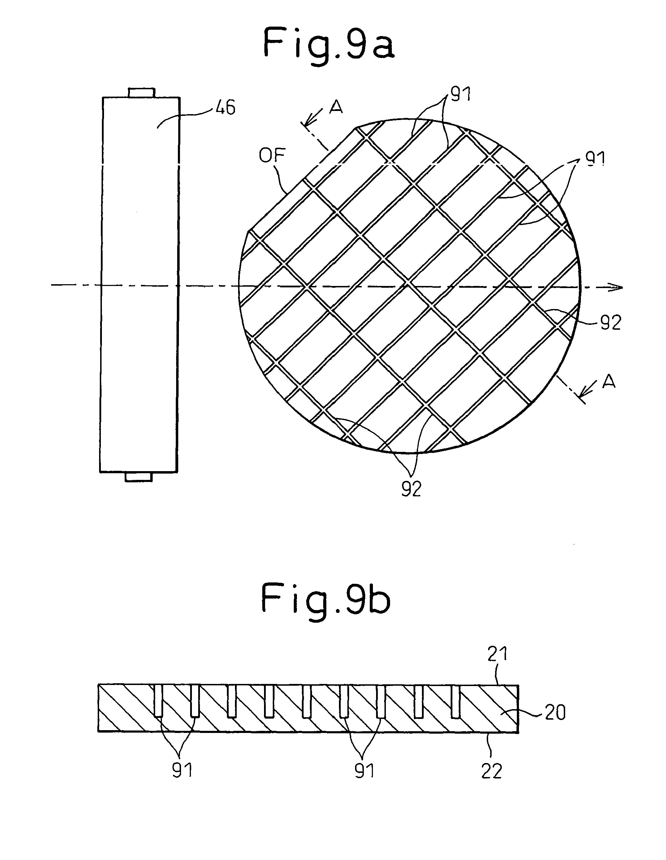

Fig. 9a is a schematic plan view showing a wafer, which has been half-cut, and also showing a roller in the sticking unit, and Fig. 9b is a sectional view taken on line A - A in Fig. 9a. As shown in Fig. 9a, relatively wide grooves, which are formed by the dicing device along the pattern grooves "ga" and "gb" (shown in Fig. 4) on the front surface 21 of the wafer 20, are formed, that is, the streets 91, 92 are formed. As can be seen in Fig. 9b, the street 91 is cut to about half the thickness of the wafer 20.

As described above, since the wafer 20, which has been half-cut, is not perfectly separated, the wafer 20 is subjected to the processing described before in each unit of the wafer processing device 100, and the same effect as that described before can be provided. That is, the scope of the present invention includes that the surface protective film 3 is stuck and peeled off with respect to the wafer 20 which has been half-cut.

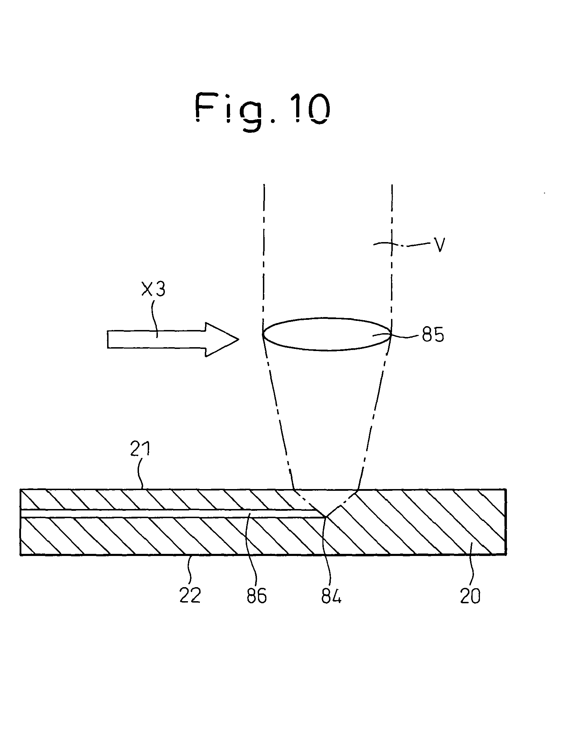

In this connection, in addition to the case in which the wafer 20 is half-cut by a common dicing device having a dicer blade, the wafer 20 may be half-cut by means of laser beam dicing. Fig. 10 is a sectional side view for explaining the means of laser beam dicing. In Fig. 10, under the condition that the multiple photon absorption is caused, the laser beam is irradiated from a laser beam source not shown onto the front surface 21 side of the wafer 20 through the condenser lens 85. In this case, the condensing point 84 is adjusted to a position somewhat close to the front surface 21 inside the wafer 20. Due to the foregoing, a reformed region is formed round the condensing point 84. Next, when the laser beam V and the condenser lens 85 are moved along the arrow X3, a belt-shaped reformed region 86 is formed inside the wafer 20.

By the means of laser beam dicing, the laser beam V is transmitted through the wafer 20, and the multiple photon absorption is generated inside the wafer 20 so that a reformed region can be formed. Accordingly, the laser beam V is seldom absorbed on the front surface 21 of the wafer 20. As a result, there is no possibility that the front surface 21 of the wafer 20 is melted. A plurality of the reformed regions 86 described above are formed along the pattern grooves "ga" and "gb" of the wafer 20.

As the reformed region 86 is formed on the side somewhat close to the front surface 21, when the reformed region 86 cracks spontaneously toward the front surface 21 in the thickness direction, a street is formed corresponding to the width of the laser beams V. Due to the foregoing, the dicing of half-cut is conducted. Concerning this dicing of half-cut, refer to Fig. 9b.

In the case where the method of laser beam dicing for fully cutting the wafer is employed in the dicing device 600 shown in Fig. 1, a plurality of the reformed regions 86 are formed in the thickness direction. In this case, when the reformed regions 86 crack in the thickness direction, the reformed regions 86, which are adjacent to each other, are connected, so that the entire thickness portion of the wafer 20 can be cracked. This system can be employed in the dicing device 600 shown in Fig. 1

In this connection, in the present invention, it is most preferable that the moving directions X1 and X2 of the roller 46 and the peeling roller 146 are arranged in parallel with the bisector of the pattern corner portion at the time of sticking and peeling the surface protective film 3. However, it is also preferable that the moving directions X1 and X2 cross the bisector, making a certain angle, for example, the moving directions X1 and X2 cross the bisector, making an angle not more than 30°. It should be noted that this case is included in the scope of the present invention.

In the embodiment described above, the circuit pattern C is supposed to be a rectangle. However, the circuit pattern C may be formed into a shape other than a rectangle. When the wafer 20 is positioned so that the bisector of the corner portion of the circuit pattern C can be parallel with the moving directions X1 and X2 of the roller 46 and the peeling roller 146, it is clear that the same effect as that described before can be provided.

## Claims

1. A film sticking method for sticking a film on a pattern forming face of a wafer, on the pattern forming face of which circuit patterns are formed, comprising the steps of:
positioning the wafer so that a sticking direction of a film sticking means for sticking the film on the pattern forming face by moving the film sticking means in a predetermined sticking direction on the pattern forming face of the wafer can be substantially parallel with the bisector of a corner portion of the circuit pattern; and
sticking the film on the pattern forming face of the wafer by moving the film sticking means in the sticking direction on the pattern forming face of the wafer.

2. A method according to claim 1, wherein the positioning step comprises positioning the wafer in a first orientation so that the sticking direction of the film sticking means can be substantially parallel with the bisector of the corner portion of the circuit pattern;
the method further comprising grinding a face on the opposite side to the pattern forming face of the wafer;
positioning the wafer in a second orientation rotated by 90° round the centeraxis of the wafer from the first direction;
feeding a peeling tape onto the film stuck on the pattern forming face of the wafer;
contacting the peeling tape with the film on the wafer; and
peeling the film together with the peeling tape from the pattern forming face on the wafer by moving a film peeling means in a peeling direction, which is parallel with the sticking direction, on the pattern forming face of the wafer.

3. A film sticking method according to claim 1 or 2, wherein the wafer is previously cut by dicing operation to an intermediate portion of the wafer thickness.

4. A film sticking device for sticking a film on a pattern forming face of a wafer, on the pattern forming face of which circuit patterns are formed, comprising:
a positioning means for supportably positioning the wafer; and
a film sticking means for sticking the film on the pattern forming face by moving the film sticking means in a predetermined sticking direction on the pattern forming face of the wafer, wherein
after the wafer is positioned by the positioning means so that the sticking direction of the film sticking means can be substantially parallel with the bisector of a corner portion of the circuit pattern, the film is stuck on the pattern forming face of the wafer by moving the film sticking means in the sticking direction on the pattern forming face of the wafer.

5. A device according to claim 4, further comprising a grinding means for grinding a face on the opposite side to the pattern forming face of the wafer;
a tape feeding means for feeding a peeling tape onto the film stuck on the pattern forming face of the wafer; and
a film peeling means for peeling the film together with the peeling tape from the pattern forming face of the wafer by moving the film peeling means in a peeling direction parallel with the sticking direction on the pattern forming face, wherein
after the wafer is positioned by the positioning means in a first orientation so that the sticking direction of the film sticking means can be substantially parallel with the bisector of a corner portion of the circuit pattern, the film is stuck on the pattern forming face of the wafer by moving the film sticking means in the sticking direction on the pattern forming face of the wafer,
after a face on the opposite side to the pattern forming face is ground by the grinding means, the wafer is positioned by the positioning means in a second orientation rotated by 90° round the centeraxis of the wafer from the first direction so as to contact the film of the wafer with the peeling tape fed by the feeding means, and
the film is peeled from the pattern forming face of the wafer together with the peeling tape by moving the film peeling means in a peeling direction parallel with the sticking direction on the pattern forming face.

6. A film sticking device according to claim 4 or 5, wherein the wafer is previously cut by dicing operation to an intermediate portion of the wafer thickness.
